# EUROPEAN PATENT APPLICATION

(11) **EP 4 542 549 A1**
(43) Date of publication of application: **23.04.2025**
(21) Application number: 23204809.0
(22) Date of filing: 20.10.2023
(51) Int. Cl.: G11C 11/22, H10B 53/20

(54) **3D FERROELECTRIC MEMORY STRUCTURE AND METHOD FOR READING-OUT THE MEMORY STRUCTURE**

(71) Applicant: Imec VZW, 3001 Leuven (BE)
(72) Inventor: Van Houdt, Jan, 3001 Leuven (BE)
(74) Representative: Roth, Sebastian

(57) **Abstract**

The present disclosure relates to a three-dimensional (3D) ferroelectric memory structure, and a method for its read-out. The memory structure comprises a substrate, and a layer stack arranged on the substrate, the layer stack comprising multiple dielectric layers and first metallic layers alternatingly arranged along a first axis. A first ferroelectric layer extends through the layer stack and a second metallic layer extends through the layer stack adjacent to the first ferroelectric layer. The first ferroelectric layer forms, in combination with the plurality of first metallic layers and the second metallic layer, a plurality of first capacitive memory cells. A first work function of the first metallic layers may be different from a second work function of the second metallic layer or may be the same. The read-out may comprise applying a DC bias voltage to the first ferroelectric layer, which is lower than a voltage required to change a current polarization state of the first ferroelectric layer, detecting a capacitance of the first ferroelectric layer at the bias voltage and correlating it to a current polarization state of the first ferroelectric layer.

## Description

### TECHNICAL FIELD

The present disclosure relates to the field of capacitor-based ferroelectric memories. In particular, the present disclosure provides a three-dimensional (3D) ferroelectric memory structure, a memory device comprising a plurality of 3D ferroelectric memory structures, and a method for reading-out a 3D ferroelectric memory structure.

### BACKGROUND

A ferroelectric random access memory (FeRAM) uses a ferroelectric memory structure with a ferroelectric layer to store information. FeRAMs often consist of a grid of memory cells, wherein each memory cell comprises a ferroelectric capacitor and a select transistor (so-called 1T-1C devices). The ferroelectric layer is thereby arranged between the capacitor plates to form the ferroelectric capacitor.

To read-out the current memory state of such a memory cell, the memory cell is forced to a known memory state, i.e., to a particular net polarization (up or down) of the ferroelectric layer. Based on the response of the memory cell, it can be deduced whether the memory state of the ferroelectric layer has changed as a result or not. Thus, in 50% of the cases, on average, the current memory state of the memory cell is overwritten during the read-out, and the memory cell needs to be reprogrammed afterwards. This is called a destructive read-out. Because of this destructive read-out, the endurance of the memory cell, i.e., the total number of attainable write/erase cycles, is linked to the number of read cycles. This leads generally to more demanding specifications. For instance, a memory cell should endure up to 1E13 write/erase cycles or more.

Furthermore, the switching power is determined by the polarization value of the ferroelectric layer, which can be quite high. Since the memory cells are switched in 50% of all read cycles, reading requires a voltage that is sufficiently high to switch the memory cell to a known memory state and requires an additional rewrite cycle, both adding to the power consumption.

Moreover, the select transistor, which is typically used for decoding of the memory cell in the 1T-1C configuration, enlarges the size of the memory cell and makes it non-stackable, especially when using silicon transistors.

However, a 3D stacking of memory cells is highly desirable, as this may increase the memory density without requiring an aggressive scaling of the lateral dimension. So far, this approach has proven to be successful in the case of Flash memory (e.g., 3D NAND), but similar architectures for memory-type storage class memories (SCM) and compute-in-memory (CiM) applications are not yet established. In particular within the SCM field, no satisfying solution has yet been found, as most concepts rely on resistance switching, which implies high currents and power consumption.

### SUMMARY

In view of the above, it is an objective of this disclosure to provide an improved ferroelectric memory structure suitable for designing a FeRAM, and an improved method for reading-out the ferroelectric memory structure in a non-destructive manner. Another objective is to provide the ferroelectric memory structure in 3D, i.e., with stacked memory cells. An overall objective is to avoid the above-mentioned disadvantages.

These and other objectives are achieved by the solutions provided in the independent claims. Advantageous implementations are described in the dependent claims.

A first aspect provides a 3D ferroelectric memory structure comprising: a substrate; a layer stack arranged on the substrate, wherein the layer stack comprises a plurality of dielectric layers and first metallic layers, which are alternatingly arranged one on the other along a first axis; a first ferroelectric layer extending through the layers of the stack; and a second metallic layer extending through the layers of the stack adjacent to the first ferroelectric layer; wherein the first ferroelectric layer forms, in combination with the plurality of first metallic layers and the second metallic layer, a plurality of first capacitive memory cells; and wherein a first work function of the first metallic layers is different from a second work function of the second metallic layer.

The first aspect accordingly provides a ferroelectric memory structure in 3D, i.e., with stacked memory cells, which may increase the memory (cell) density of a memory device, e.g. FeRAM, which incorporates the 3D ferroelectric memory structure.

Further, the 3D ferroelectric memory structure of the first aspect provides the advantage that the memory cells can be read out in a non-destructive way. In particular, the different work functions of the first metallic layers and the second metallic layer cause an asymmetry of a hysteresis loop of the ferroelectric layer, and especially cause also an asymmetry of the capacitance-voltage hysteresis. Due to this asymmetry of the capacitance-voltage hysteresis, a capacitance and, thus, a dielectric response of the 3D ferroelectric memory structure differs depending on the current polarization state of the ferroelectric layer, even if no bias voltage is applied to the ferroelectric layer. This difference in capacitance (or dielectric response) may also be referred to as a memory window.

As a consequence, the current polarization state of the ferroelectric layer can be detected by measuring a dielectric response (e.g., an effective permittivity or capacitance) of the ferroelectric layer, even if no (or only a small) bias voltage is applied. Hence, a memory state of the memory structure can be read-out without having to "switch" the polarization of the ferroelectric layer (non-destructive read out (NDRO)), as even the small bias voltage can be below the voltage required to switch the ferroelectric layer.

Notably, each first metallic layer, the ferroelectric layer and the second metallic layer can together form a respective ferroelectric capacitor for implementing a first capacitive memory cell. The first metallic layer and the second metallic layer can thereby form the capacitor plates of said ferroelectric capacitor. Considering one memory cell of all the first capacitive memory cells, the respective first metallic layer may completely surround the ferroelectric layer of that memory cell, while the ferroelectric layer surrounds the second metallic layer. The ferroelectric layer and the second metallic layer may have a cylindrical shape in this case, and may be formed in so-called memory holes through the stack. Alternatively, the first metallic layer may be arranged on one side of the ferroelectric layer, and the second metallic layer may be arranged on the other side of the ferroelectric layer along a second axis perpendicular to the first axis.

The fact that the first metallic layers and the second metallic layer have different work functions may mean that they comprise, or are formed from, materials (or material compositions) with different work functions. For instance, the first metallic layers may have a first work function, and the second metallic layer may have a second work function, which is different from the first work function.

The substrate can be a silicon substrate, in particular, it may be a p-doped silicon substrate. The stack may be deposited directly on the substrate. However, one or more other layers could be arranged between substrate and stack.

In an implementation, the 3D ferroelectric memory structure further comprises: a second ferroelectric layer extending through the layers of the stack; and a third metallic layer extending through the layers of the stack adjacent to the second ferroelectric layer; wherein the second ferroelectric layer forms, in combination with the plurality of first metallic layers and the third metallic layer, a plurality of second capacitive memory cells; and wherein the first work function of the first metallic layers is different from a third work function of the third metallic layer.

Thus, additional memory cells can be processed in the same stack, which may increase the memory density.

In an implementation, the 3D ferroelectric memory structure further comprises a dielectric material extending through the layers of the stack and arranged between the second metallic layer and the third metallic layer.

According to the above implementations, multiple first capacitive memory cells and multiple second capacitive memory cells can be processed and arranged adjacently in the stack. The first and second ferroelectric layer, the second and third metallic layer, and the dielectric material may be formed adjacently in a trench previously formed in the layer stack.

In an implementation of the 3D ferroelectric memory structure, both the first ferroelectric layer and the second ferroelectric layer extend along the first axis or extend tilted at opposite angles with respect to the first axis.

Thus, the first ferroelectric layer and the second ferroelectric layer may be parallel to each other, but may also extend with an angle between each other.

In an implementation of the 3D ferroelectric memory structure, the first ferroelectric layer and the second ferroelectric layer are respectively electrically excitable to two polarization states; and each polarization state represents a memory state of respectively the first or second capacitive memory cells.

The polarization states, to which the ferroelectric layer can be electrically excited, may refer to the "net polarization" of the electric dipoles in the ferroelectric layer. The two polarization states can be represented as "up" or "down" polarization, wherein one polarization state represents a "o" and the other polarization state represents a "1" or vice versa.

In an implementation of the 3D ferroelectric memory structure, each first metallic layer of the plurality of first metallic layers is connected to a respective wordline driver.

Thus, the first metallic layers may act as wordlines and/or each first metallic layer may form at least a part of one wordline.

In an implementation of the 3D ferroelectric memory structure, each metallic layer of the second metallic layer and the third metallic layer is connected to a respective sensing circuit.

Thus, the second and third metallic layer may act as bitlines and/or each of these metallic layers may form at least a part of one bitline.

In an implementation of the 3D ferroelectric memory structure, each sensing circuit is formed in the substrate.

Thus, a compact design of the 3D ferroelectric memory structure can be obtained.

In an implementation, the 3D ferroelectric memory structure, the first work function differs from the second work function and/or from the third work function by at least 0.3 eV.

In an implementation of the 3D ferroelectric memory structure, the first metallic layers comprise a different material or material composition than the second metallic layer and/or the third metallic layer.

In an implementation of the 3D ferroelectric memory structure, at least one of the first metallic layers, the second metallic layer, and the third metallic layer comprises any one of the following materials or material compositions: molybdenum (Mo); a composition comprising molybdenum and a molybdenum oxide (MoOx); titanium nitride (TiN); a composition comprising ruthenium (Ru) and titanium nitride; or tungsten (W).

In an implementation of the 3D ferroelectric memory structure, the first ferroelectric layer comprises hafnium-zirconium oxide (HZO), for example, lanthanum doped HZO.

The first ferroelectric layer may additionally or alternatively comprise any other suitable ferroelectric material, such as hafnium-oxide (HfO₂) or lead zirconate titanate (PZT). The second ferroelectric layer may comprise HZO, for example, lanthanum doped HZO. The second ferroelectric layer may comprise the same material as the first ferroelectric layer.

In an implementation of the 3D ferroelectric memory structure, each first metallic layer and the second metallic layer are configured to apply a DC bias voltage to the ferroelectric layer, wherein the DC bias voltage is lower than a voltage required to change a current polarization state of the ferroelectric layer.

The DC bias voltage can additionally increase a difference between the dielectric responses of the two polarization states (memory window) of the ferroelectric layer. However, the DC bias voltage can be lower than a voltage required to switch the polarization state of the ferroelectric layer. Thus, the memory state of the memory structure can still be read out in a non-destructive way.

A second aspect provides a memory device comprising a plurality of 3D ferroelectric memory structures according to the first aspect or any implementation thereof, wherein the 3D ferroelectric memory structures are arranged in a crossbar array.

Each 3D ferroelectric structure can provide a plurality of memory cells of the memory device. The memory device can be a random access memory (RAM) device, e.g., a FeRAM. In an example, the memory device can be a selector-less memory device, i.e., the memory cells of the memory device do not comprise an additional select transistor for the capacitor (i.e., they are in a so-called 0T-1C configuration). This achieves the advantage that the memory cells can be arranged denser and may be stacked even better. Furthermore, the 3D ferroelectric memory structure(s) can be back end of line (BEOL) compatible.

A third aspect provides a method for reading out a 3D ferroelectric memory structure wherein the 3D ferroelectric memory structure comprises a layer stack arranged on a substrate, the layer stack comprising a plurality of dielectric layers and first metallic layers alternatingly arranged one on the other along a first axis, a first ferroelectric layer extending through the layers of the stack, and a second metallic layer extending through the layers of the stack adjacent to the first ferroelectric layer, the first ferroelectric layer forming, in combination with the plurality of first metallic layers and the second metallic layer, a plurality of first capacitive memory cells, wherein the method comprises: applying a DC bias voltage to the first ferroelectric layer by means of one of the first metallic layers and the second metallic layer, wherein the DC bias voltage is lower than a voltage required to change a current polarization state of the first ferroelectric layer; detecting a capacitance of the first ferroelectric layer at the bias voltage; and correlating the detected capacitance to a current polarization state of the first ferroelectric layer.

The method of the third aspect achieves similar advantages as described above for the 3D ferroelectric memory structure of the first aspect, especially enables a non-destructive read-out of the memory cells.

In particular, applying the bias voltage causes or increases a capacitance difference between the two polarization states of the ferroelectric layer. At the bias voltage, the capacitance-voltage loop of the ferroelectric layer exhibits a bigger gap (i.e., a bigger memory window) between the capacitance values of the polarization states. This memory window can be used to read-out the polarization state. However, since the bias voltage is still lower than the voltage required to change the current polarization state of the ferroelectric layer, the read-out can be non-destructive to the current memory state. Here, capacitance of the ferroelectric layer may refer to the capacitance of the capacitive memory cells, which are formed using the ferroelectric layer and the respective metallic layers.

In an implementation, the first metallic layers and the second metallic layer are formed from the same material or material composition. Hence, the effect of the bias voltage can be sufficient to cause a detectable difference in the dielectric response of the ferroelectric layer depending on its polarization state that can be read-out in a non-destructive way.

In an implementation, the first metallic layers and the second metallic layer comprise different materials or material compositions. This achieves the advantage that the difference between the dielectric responses of the two polarization states of the ferroelectric layer can be further enhanced, thus, increasing the "memory window".

In an implementation, a first work function of the first metallic layers is different from a second work function of the second metallic layer.

This increases the memory window at small DC bias voltages. In fact, a memory window may even exist at zero bias voltage.

In an implementation of the method, the capacitance of the first ferroelectric layer is detected by applying an AC voltage signal to one side of the first ferroelectric layer and detecting a dielectric response of the first ferroelectric layer by means of the AC voltage signal at the other side of the first ferroelectric layer.

The dielectric response can comprise a displacement current, which is generated after a build-up of a displacement charge due to the AC voltage signal. The AC voltage signal (e.g., 30 mV or 100 mV or 500 mV pulses) can be applied to one of the first metallic layers, in particular to the first metallic layer that is connected to a word line, and can cause the build-up of a displacement charge in the first capacitive memory cell. The dielectric response can be detected on a bit line that is connected to the second metallic layer.

### BRIEF DESCRIPTION OF THE DRAWINGS

The above described aspects and implementations are explained in the following description of embodiments with respect to the enclosed drawings:
- FIG. 1: shows a part of a 3D ferroelectric memory structure according to this disclosure.
- FIG. 2: shows a first example of a 3D ferroelectric memory structure according to this disclosure.
- FIG. 3: shows a second example of a 3D ferroelectric memory structure according to this disclosure.
- FIG. 4: shows optional details of the 3D ferroelectric memory structure of FIG. 3.
- FIG. 5: shows a flow diagram of a method for reading-out a 3D ferroelectric memory structure according to this disclosure.
- FIG. 6: shows diagrams of measurements using a 3D ferroelectric memory structure according to this disclosure.
- FIG. 7: shows a schematic diagram of a memory device according to this disclosure.

### DETAILED DESCRIPTION OF EMBODIMENTS

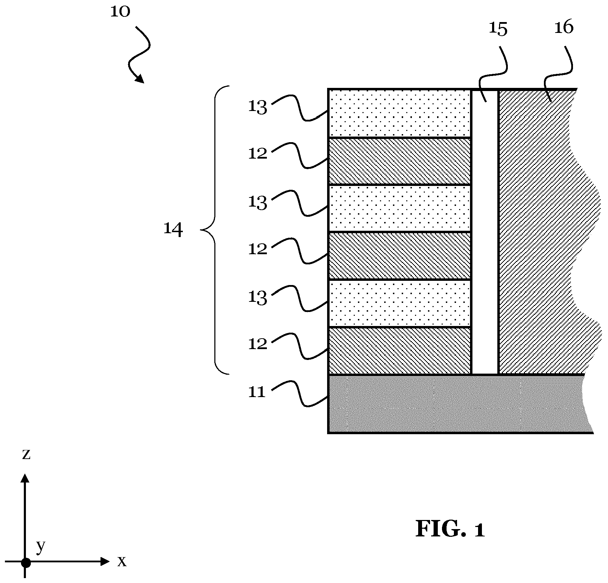

FIG. 1 shows a 3D ferroelectric memory structure 10 according to this disclosure. The 3D ferroelectric memory structure 10 may be used to build a memory device, for instance, a FeRAM. The memory device may comprise one or multiple such 3D ferroelectric memory structures 10, and may be configured to store information into one or more memory cells, which are provided by the design of the 3D ferroelectric memory structure 10.

The 3D ferroelectric memory structure 10 comprises a substrate 11, for instance, a silicon substrate, and a layer stack 14 arranged directly on (as shown) or above the substrate 11. The layer stack 14 comprises a plurality of dielectric layers 13 and first metallic layers 14, which are alternatingly arranged one on the other along a first axis. The first axis defines the stacking direction of the layer stack 14, and is aligned with the (vertical) z-axis of a coordinate system with x-axis, y-axis, and z-axis in FIG. 1.

The 3D ferroelectric memory structure 10 further comprises a first ferroelectric layer 15, which extends through the layers 12, 13 of the stack 14. The ferroelectric layer 15 may extend through all the layers 12, 13 of the stack 14, and may land on the substrate 11 (as shown). The first ferroelectric layer 15 may extend along the first axis (as shown), and may thus extend perpendicular to surfaces of the layers 12, 13 of the layer stack 14. The stack 14 may either start with a first metallic layer 12 or with a dielectric layer 13 (as the bottom-most layer of the stack 14), for instance, provided or grown directly on the substrate 11. The layer stack 14 may likewise end with first metallic layer 12 or with a dielectric layer 13 (as the top-most layer of the stack 14, i.e., the layer farthest away from the substrate 11), and the illustrated stack 14 of FIG. 1 is just an example.

The 3D ferroelectric memory structure 10 further comprises a second metallic layer 16 extending through the layers 12, 13 of the stack 14 adjacent to the first ferroelectric layer 15. Thus, the second metallic layer 16 may extend along the first axis, and may thus extend perpendicular to surfaces of the layers 12, 13 of the layer stack 14. The second metallic layer 16 may be provided on the first ferroelectric layer 15.

The first ferroelectric layer 15 forms, in combination with the plurality of first metallic layers 12 and the second metallic layer 16, a plurality of first capacitive memory cells. Each of these first capacitive memory cells may be formed by a capacitor including one of the first metallic layers 12 and the second metallic layer 16 as capacitor plates, and the first ferroelectric layer 15 as dielectric in between the capacitor plates.

A first work function of the first metallic layers 12 may be different from a second work function of the second metallic layer 16. In this case, a non-destructive read out of the first capacitive memory cells of the 3D ferroelectric memory structure 10 is possible at zero bias voltage, as will be explained below. The first work function of the first metallic layers 12 may also be the same as the second work function of the second metallic layer 16. In this case, a non-destructive read out of the first capacitive memory cells of the 3D ferroelectric memory structure 10 is possible by applying a small DC bias voltage, as will also be explained below.

The first metallic layers 12 and the second metallic layer 16 may respectively comprise one or more of molybdenum; a composition comprising molybdenum and a molybdenum oxide; titanium nitride; a composition comprising ruthenium and titanium nitride; and tungsten. They can both be selected from these materials or material combinations, wherein the first metallic layers 12 and the second metallic layer 16 may comprise different materials or material combinations or the same.

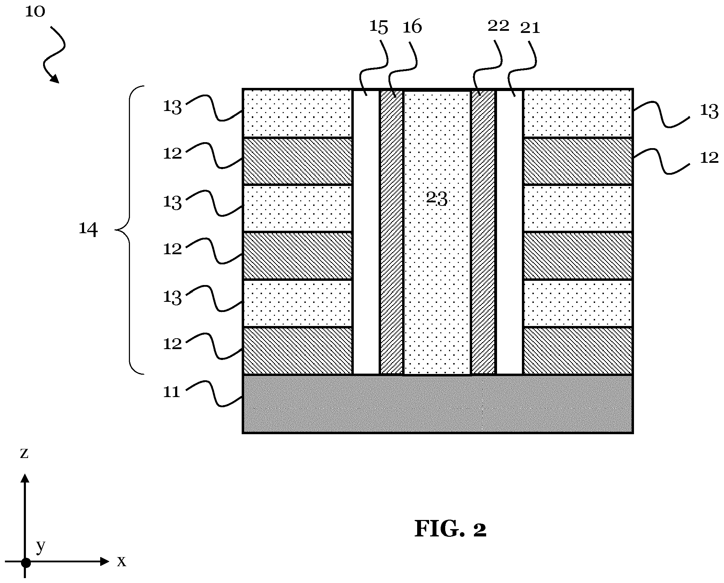

Note only a part of the 3D ferroelectric memory structure 10 is shown in FIG. 1, while another part is not shown (to the right side in FIG. 1, indicated by the meandering edge). Different implementations are possible here on this side, for example, the implementation presented next with regard to FIG. 2.

FIG. 2 shows a first example of a 3D ferroelectric memory structure 10 according to this disclosure, which builds on the 3D ferroelectric memory structure 10 shown in FIG. 1. Same elements in FIG. 1 and 2 share the same reference signs, and can be implemented likewise. In particular, the left side of the 3D ferroelectric memory structures 10 in FIG. 1 and FIG. 2 may be identical.

The 3D ferroelectric memory structure 10 shown in FIG. 2 further comprises (shown on the right side of FIG. 2), a second ferroelectric layer 21, which extends through the layers 12, 13 of the stack 14, and a third metallic layer 22 extending through the layers 12, 13 of the stack 14 adjacent to the second ferroelectric layer 21. The second ferroelectric layer 21 may extend along the first axis (as shown), and may thus extend perpendicular to surfaces of the layers 12, 13 of the layer stack 14. Accordingly, the first ferroelectric layer 15 and the second ferroelectric layer 21 may extend in parallel to another. Also the third metallic layer 22 may extend along the first axis, and may thus extend perpendicular to the surfaces of the layers 12, 13 of the layer stack 14. The third metallic layer 22 may be provided on the second ferroelectric layer 21.

The second ferroelectric layer 21 forms, in combination with the plurality of first metallic layers 12 and the third metallic layer 22, a plurality of second capacitive memory cells. Each of these second capacitive memory cells may be formed by a capacitor including one of the first metallic layers 12 and the third metallic layer 22 as capacitor plates, and the second ferroelectric layer 21 as dielectric in between the capacitor plates. A first work function of the first metallic layers 12 may be different from a third work function of the third metallic layer 22, or may be the same. The second capacitive memory cells may accordingly be read-out non-destructively respectively at zero bias voltage or with a small DC bias voltage, as described above for the first capacitive memory cells, and described below in more detail. The work functions of the second metallic layer 16 and the third metallic layer 22 may be different, but are preferably identical. The third metallic layer 22 may comprise one or more of molybdenum; a composition comprising molybdenum and a molybdenum oxide; titanium nitride; a composition comprising ruthenium and titanium nitride; and tungsten. The third metallic layer 22 may comprise a different material or material combination than the first metallic layers 12. The third metallic layer 22 may comprise a different material or material combination than the second metallic layer 16, but preferably has the same material or material composition than the second metallic layer 16.

The 3D ferroelectric memory structure 10 shown in FIG. 2 further comprises a dielectric material 23, which extends through the layers 12, 13 of the stack 14 and is arranged between the second metallic layer 22 and the third metallic layer 16. The dielectric material 23 may be the same as that used for the dielectric layers 13. For instance, the dielectric materials 13, 13 may be an oxide, for instance, a silicon oxide.

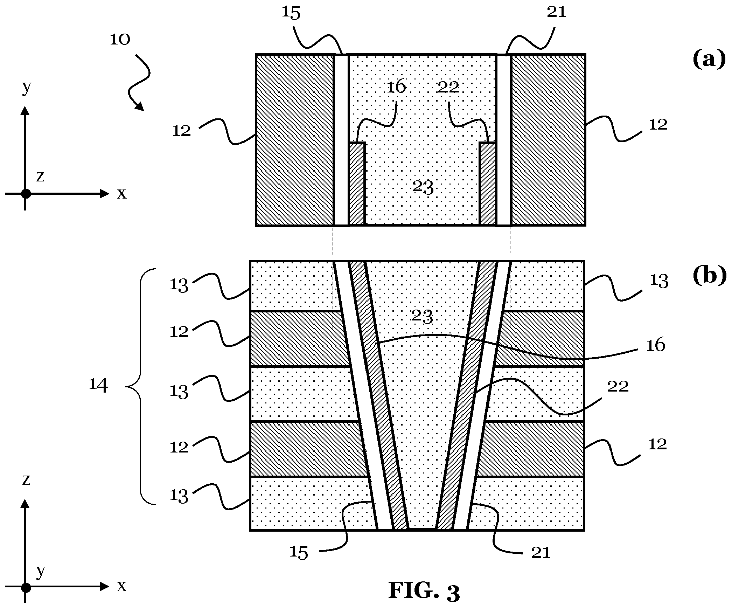

FIG. 3 shows a second example of a 3D ferroelectric memory structure 10 according to this disclosure, which is similar to the structures 10 shown in FIG. 1 and 2. Same elements in FIG. 1, 2 and 3 share the same reference signs, and can be implemented likewise. In particular, FIG. 3(a) shows a cross-sectional view along the z-axis, while FIG. 3(b) shows a cross-sectional view along the y-axis, as also FIG. 1 and FIG. 2.

Unlike what is shown in FIG. 2, in the 3D ferroelectric memory structure 10 shown in FIG. 3, the first ferroelectric layer 15 and the second ferroelectric layer 21 extend at opposite angles with respect to the first axis. That is, a distance between the two ferroelectric layers 15, 21 changes along their extensions, which may lead to a tapered shape of the arrangement of the two ferroelectric layers (as shown). Also the second metallic layer 16 and the third metallic layer 22 extend at (the same) opposite angles with respect to the first axis.

As can be further seen in FIG. 3(a), the second metallic layer 16 and the third metallic layer 22 have a shorter respective extension along the y-axis (generally, a third axis perpendicular to the first axis and the second axis, i.e., x-axis) as the first ferroelectric layer 15 and the second ferroelectric layer 21, respectively.

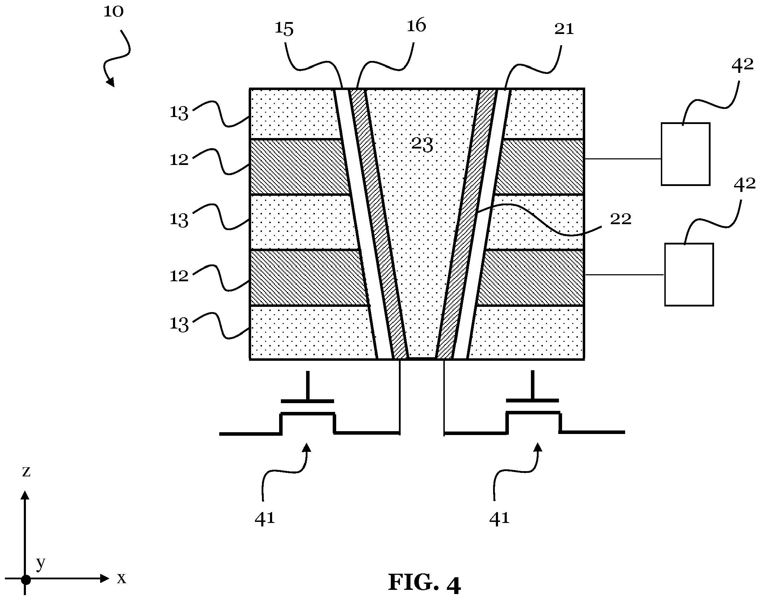

FIG. 4 shows further optional details of the 3D ferroelectric memory structure 10 of FIG. 3. In particular, FIG. 4 shows that each first metallic layer 12 of the plurality of first metallic layers 12 may be connected to a respective wordline driver 42. Each first metallic layer 12 thus acts as a wordline (or is part of a wordline) for selecting one or more memory cells implemented by the 3D ferroelectric memory structure 10. For instance, one first capacitive memory cell and one second capacitive memory cell maybe selected by each wordline (i.e. per first metallic layer 12) in the shown 3D ferroelectric memory structure 10. Further, each of the second metallic layer 16 and the third metallic layer 22 is connected to a respective sensing circuit 41 (also referred to as read-out circuit), and thus acts as a bitline (or is part of a bitline). The sensing circuits may be transistors and may be used to read-out one or more memory cells selected by the activated wordline. In particular, each sensing circuit may read-out one memory cell selected by the activated wordline.

Overall, the 3D ferroelectric memory structure 10 may comprise a number N of stacked capacitors with horizontal (along the x-axis) wordlines and vertical (along the z-axis) bitlines. The metallic layers 16, 22 related to the bitlines may be connected to the read out (sensing) circuits 41 in the substrate 11. Each sensing circuit 41 may be formed in the substrate 11. One sensing circuit 41 is associated with the N capacitors connected to the respective vertical bitline.

The 3D ferroelectric memory structure 10 of this disclosure may be a NAND-type back end of line (BEOL) memory. This disclosure may provide a true X-point memory architecture. The ferroelectric memory structure 10 can be used for CiM applications or as FeRAM. Asymmetric reading can be done by the work function difference of the magnetic materials 12, 16, 22, and may be enhanced by applying a read bias.

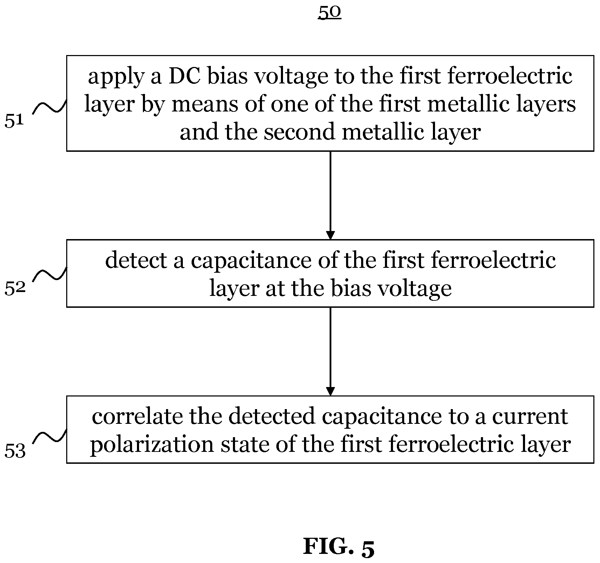

FIG. 5 shows a flow diagram of a method 50 for reading-out a 3D ferroelectric memory structure 10 according to this disclosure. For instance, as shown in the FIGs. 1-4, respectively. In the 3D ferroelectric memory structure 10 that is read-out with the method 50, the first metallic layers 12 and the second metallic layer 16 may have different work functions or not.

In order to non-destructively read-out a first capacitive memory cell of the 3D ferroelectric memory structure 10, the method 50 comprises a step 51 of applying a DC bias voltage to the first ferroelectric layer 15 by means of one of the first metallic layers 12 and the second metallic layer 16, wherein the DC bias voltage is lower than a voltage required to change a current polarization state of the first ferroelectric layer 15. Further, the method 50 comprises a step 52 of detecting a capacitance of the first ferroelectric layer 15 at the bias voltage, and a step 53 of correlating the detected capacitance to a current polarization state of the first ferroelectric layer 15. If the first metallic layers 12 and the second metallic layer 16 have different work functions, the DC bias voltage may even be zero or close to zero.

Similarly, in order to non-destructively read-out a second capacitive memory cell of the 3D ferroelectric memory structure 10, the method 50 comprises a step of applying a DC bias voltage to the second ferroelectric layer 21 by means of one of the first metallic layers 12 and the third metallic layer 22, wherein the DC bias voltage is lower than a voltage required to change a current polarization state of the second ferroelectric layer 21. Further, the method 50 comprises a step of detecting a capacitance of the second ferroelectric layer 21 at the bias voltage, and a step of correlating the detected capacitance to a current polarization state of the second ferroelectric layer 21. If the first metallic layers 12 and the third metallic layer 22 have different work functions, the DC bias voltage may even be zero or close to zero.

The steps of applying the DC bias voltages to the first ferroelectric layer 15 and the second ferroelectric layer, respectively, may be done in parallel by using the same one of the first metallic layers 12 as wordline.

The capacitances of respectively the first ferroelectric layer 15 and the second ferroelectric layer 21 may be detected by applying an AC voltage signal to one side of the first ferroelectric layer 15 or second ferroelectric layer 21, and detecting a dielectric response of the first ferroelectric layer 15 or second ferroelectric layer 21 by means of the AC voltage signal at the other side of the first ferroelectric layer 15 or second ferroelectric layer 21. This AC voltage signal may be detected via the metallic layers 16, 22 using sensing circuits 41.

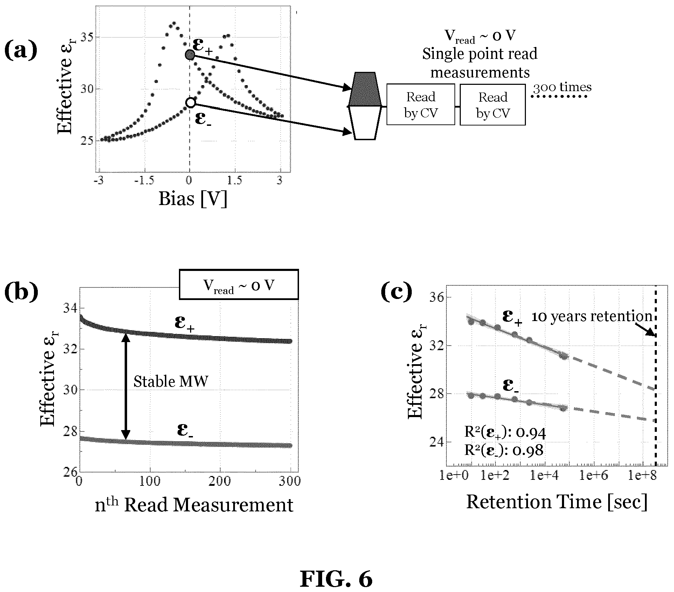

FIG. 6 shows diagrams of measurements using a 3D ferroelectric memory structure 10 according to this disclosure.

FIG. 6(a) show a C-V characteristic of the ferroelectric memory structure 10. Thereby, the x-axis shows a bias voltage that is applied to the first ferroelectric layer 15, and the y-axis shows the effective permittivity of the first ferroelectric layer 15 (which is linearly related to the capacitance). The curve in FIG. 6(a) can thus also be referred to as epsilon-bias-curve.

In particular, the C-V characteristic shown in FIG. 6(a) demonstrates that an asymmetry in work functions of the first metallic layers 12 and the second metallic layers 16 on the opposite sides of the ferroelectric layer 15 leads to an asymmetry in the curve. That is, even at a zero bias voltage (of o V), the capacitance of the first ferroelectric layer 15 differs depending on the polarization state of the first ferroelectric layer 15 (e.g., up or down). The asymmetry in the epsilon-bias-curve allows detecting the polarization state of the capacitor (i.e., one of the first capacitive memory cells that is read-out) at even zero bias voltage, without switching the first ferroelectric layer 15 (i.e., a non-destructive read out). This allows for very low power (deep low power mode) nonvolatile memory elements, which exhibit very high read endurance and are suitable for selector-less operation.

In FIG. 6(a), the effective permittivity values of the first ferroelectric layer 15 in the first polarization state (ε₊) and in the second polarization state (ε₋) at zero bias voltage are particularly highlighted. The difference between ε₊ and ε₋ defines a memory window (MW) of the 3D ferroelectric memory structure 10. Due to this memory window, it is possible to read data without switching/disturbing the polarization states even at zero DC voltage bias. A small DC voltage bias may be applied nevertheless.

The effective permittivity (ε₊ or ε₋) of the first ferroelectric layer 15 can, for example, be read out by applying a low AC voltage signal, e.g. 30 mV, to one of the first metallic layers 12, and observing a response at the second metallic layer 16. For instance, as explained above the first metallic layer 12 may be connected to a wordline, and the second metallic layer 16 may be connected to a bitline. Thus, the memory state can be read-out without switching/disturbing the polarization states using such wordline and bitline.

In particular, the AC voltage signal can be applied to the 3D ferroelectric memory structure 10 in the form of voltage pulses, which may cause the build-up of a displacement charge. When the 3D ferroelectric memory structure 10 subsequently discharges, a displacement current is generated, which can be measured. Based on this displacement current, the capacitance and, thus, the polarization state (memory state) of the first ferroelectric layer 15 of the 3D ferroelectric memory structure 10 can be detected.

FIG. 6(b) shows the result of approximately 300 consecutive measurements of ε+ and ε₋ at zero bias voltage (V_{read} ~ o V). These measurements show that the memory window, i.e. the difference between ε+ and ε₋, stays relatively constant over time with only a slight reduction after the first measurements.

In particular, the fact that the 3D ferroelectric memory structure 10 can be read out in a non-destructive way causes the endurance specification of the memory structure 10 to be determined by the write cycles requirement, and not by the read cycles. Furthermore, the power consumption can be much lower, as only a displacement current from the paraelectric response of the first ferroelectric layer 15 to the AC signal is required, without actually switching the first ferroelectric layer 15.

FIG. 6(c) shows measured retention times at the memory states ε₊ and ε₋. These measurements show that good retention times > 1.000 sec can be achieved.

Notably, the above-described with respect to FIG. 6(a)-(c) is similarly true for the second ferroelectric layer 16 and the read-out of the second capacitive memory cells of the 3D ferroelectric memory structure 10.

In an example, the 3D ferroelectric memory structure 10 according to this disclosure has the first metallic layers 12 and the second metallic layer 16 with the same work function, in particular, both may be made of TiN. In this example, the ferroelectric memory structure 10 yields a symmetric C-V characteristic (also referred to as symmetric butterfly curve), which has no memory window at zero voltage bias. To nevertheless perform a non-destructive read-out, a bias DC voltage of V_{read} ~ -0.5 V may be applied to, for example, the first ferroelectric layer 15 by means of the first and second metallic layers 12, 16. At this bias voltage, the effective permittivity corresponding to positive and negative polarization states will not be equal, and the difference results in a non-zero memory window. However, such a 3D ferroelectric memory structure 10 cannot be read-out at zero bias voltage. To enable non-destructive read-out, the bias voltage is selected to be lower than a voltage that would be required to change the current polarization state of the first ferroelectric layer 15.

It may be observed, for such an example of the 3D ferroelectric memory structure 10, that after up to 300 consecutive measurements of the polarization states ε+ and ε₋ at the non-zero DC read voltage of -0.5 V, the memory window slightly drops, but stays large enough to still enable a non-destructive read-out.

In another example, the 3D ferroelectric memory structure 10 has the first metallic layers 12 and the second metallic layer 16 with different work functions, in particular, it may have a first ferroelectric layer 15 made of La:HZO, first metallic layers 12 made of MoOx/M, and a second metallic layer 16 made of TiN. Due to the different work functions of these metallic layers 12 and 16, the C-V curve is asymmetric, causing a non-zero memory window at zero voltage bias. Thus, a non-destructive read-out can be made even at zero bias voltage. The memory window may nevertheless be further increased by applying a non-zero bias voltage to the first ferroelectric layer 15. The bias voltage is, thereby, lower than a voltage required to switch the memory state of the first ferroelectric layer 15.

It may be observed, for such an example of the 3D ferroelectric memory structure 10, that after up to 300 consecutive measurements of the polarization states ε+ and ε₋ at a non-zero DC read voltage of e.g. -0.3 V, an initial memory window value drops only very slightly. Thus, by combining a 3D ferroelectric memory structure 10 with a non-zero DC bias voltage (which is smaller than a voltage required to switch the memory state), a stable memory window can be created, which can be read-out in a non-destructive way.

In the above examples, DC bias voltages of, for example, -500mV or -300mV can be applied to the respective first ferroelectric layers 15. These values serve only as examples for possible non-zero read-out voltages. Other DC bias voltages (which are lower than the voltage required to change the polarization state of the ferroelectric material layer) could be chosen.

In summary, a difference in the capacitance value for the two polarization states of the first ferroelectric layer 15 (so-called memory window) can be generated by utilizing a variation in the dielectric response of the first ferroelectric layer 15, which occurs before it switches its polarization state. In this way, the polarization state can be read-out in a non-destructive way. To generate this memory window the symmetry of the system can be broken by using different work function metals on both sides of the ferroelectric layer 15. Additionally or alternatively, the memory window can be generated or aided by the use of asymmetrical write/erase voltages and/or by the application of a DC bias during read-out.

Notably, the above-described is similarly true for the second ferroelectric layer 16 and the read-out of the second capacitive memory cells of the 3D ferroelectric memory structure 10.

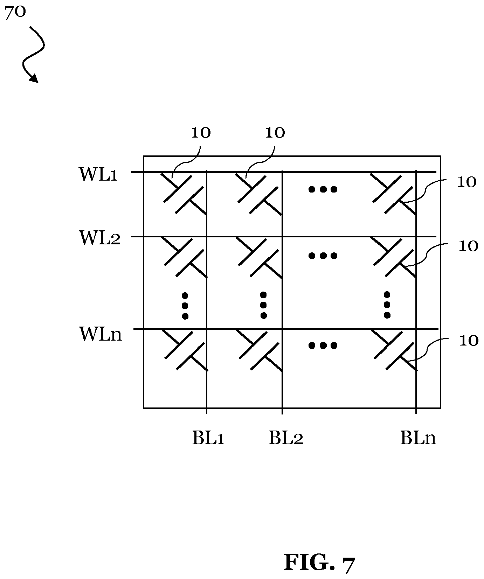

FIG. 7 shows a schematic diagram of a memory device 70 according to this disclosure. The memory device 70 comprises a plurality of 3D ferroelectric memory structures 10, for example, as shown in any one of the FIGs. 1-4. The 3D ferroelectric memory structures 10 are arranged in a crossbar array.

Preferably, the 3D ferroelectric memory structures 10 of the memory device 70 can form a selector-less, capacitor-only array (0T-1C array), i.e. a memory array without select transistors. This is possible because, the memory structures 10 do not have to be switched during read-out, which allows to remove the select transistor. Therefore, the memory structures 10 can be arranged densely and can be implemented in 3D as explained above.

Sensing of the memory states can be done by an AC voltage signal on the word lines WL1, WL2, ..., WLn which are connected to the first metallic layers 12, and detecting a dielectric response on the bit lines BL1, BL2, ..., BLn (e.g. connected to the second metallic layer 16 or to the third metallic layer 22). In this way, a very compact memory array can be generated, which can be built entirely in the back-end of the process and therefore can be evenly stacked. This can reduce the cost of the memory array.

In particular, the 3D ferroelectric memory structures 10 provide a plurality of memory cells of the memory device 70. Compared to conventional memory cells that use resistive elements (e.g., resistive RAM, Phase Change cells, MRAM), the capacitive memory structures 10 do not require an active current which strongly reduces their power consumption. The displacement current that can be used to read-out the memory structures can be much lower than an active current in conventional memories and will run only for a limited time during read-out. Thus, the memory structures 10 can be superior for CiM applications which require large memory arrays.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A three-dimensional, 3D, ferroelectric memory structure (10), comprising:
a substrate (11);
a layer stack (14) arranged on the substrate (11), wherein the layer stack (14) comprises a plurality of dielectric layers (13) and first metallic layers (12), which are alternatingly arranged one on the other along a first axis;
a first ferroelectric layer (15) extending through the layers (12, 13) of the stack (14); and
a second metallic layer (16) extending through the layers (12, 13) of the stack (14) adjacent to the first ferroelectric layer (15);
wherein the first ferroelectric layer (15) forms, in combination with the plurality of first metallic layers (12) and the second metallic layer (16), a plurality of first capacitive memory cells; and
wherein a first work function of the first metallic layers (12) is different from a second work function of the second metallic layer (16).

2. The 3D ferroelectric memory structure (10) of claim 1, further comprising:
a second ferroelectric layer (21) extending through the layers (12, 13) of the stack (14); and
a third metallic layer (22) extending through the layers (12, 13) of the stack (14) adjacent to the second ferroelectric layer (21);
wherein the second ferroelectric layer (21) forms, in combination with the plurality of first metallic layers (12) and the third metallic layer (22), a plurality of second capacitive memory cells; and
wherein the first work function of the first metallic layers (12) is different from a third work function of the third metallic layer (22).

3. The 3D ferroelectric memory structure (10) of claim 2, further comprising a dielectric material (23) extending through the layers (12, 13) of the stack (14) and arranged between the second metallic layer (16) and the third metallic layer (22).

4. The 3D ferroelectric memory structure (10) of claim 2 or 3, wherein both the first ferroelectric layer (15) and the second ferroelectric layer (21) extend along the first axis or extend tilted at opposite angles with respect to the first axis.

5. The 3D ferroelectric memory structure (10) of one of the claims 1 to 4, wherein:
the first ferroelectric layer (15) and the second ferroelectric layer (21) are respectively electrically excitable to two polarization states; and
each polarization state represents a memory state of respectively the first or second capacitive memory cells.

6. The 3D ferroelectric memory structure (10) of one of the claims 1 to 5, wherein each first metallic layer (12) of the plurality of first metallic layers (12) is connected to a respective wordline driver (42).

7. The 3D ferroelectric memory structure (10) of one of the claims 1 to 6, wherein each metallic layer (16, 22) of the second metallic layer (16) and the third metallic layer (22) is connected to a respective sensing circuit (41).

8. The 3D ferroelectric memory structure (10) of claim 7, wherein each sensing circuit (41) is formed in the substrate (11).

9. The 3D ferroelectric memory structure (10) of one of the claims 1 to 8, wherein the first work function differs from the second work function and/or from the third work function by at least 0.3 eV.

10. The 3D ferroelectric memory structure (10) of one of the claims 1 to 9, wherein the first metallic layers (12) comprise a different material or material composition than the second metallic layer (16) and/or the third metallic layer (22).

11. The 3D ferroelectric memory structure (10) of one of the claims 1 to 10, wherein at least one of the first metallic layers (12), the second metallic layer (16), and the third metallic layer (22) comprises any one of the following materials or material compositions:
- molybdenum;
- a composition comprising molybdenum and a molybdenum oxide;
- titanium nitride;
- a composition comprising ruthenium and titanium nitride; or
- tungsten.

12. The 3D ferroelectric memory structure (10) of one of the claims 1 to 11, wherein the first ferroelectric layer (15) comprises hafnium-zirconium oxide, HZO, for example, lanthanum doped HZO.

13. A memory device (80) comprising a plurality of 3D ferroelectric memory structures (10) of one of the claims 1 to 12, wherein the 3D ferroelectric memory structures (10) are arranged in a crossbar array.

14. A method (50) for reading out a 3D ferroelectric memory structure (10),
wherein the 3D ferroelectric memory structure (10) comprises a layer stack (14) arranged on a substrate (11), the layer stack (14) comprising a plurality of dielectric layers (13) and first metallic layers (12) alternatingly arranged one on the other along a first axis, a first ferroelectric layer (15) extending through the layers (12, 13) of the stack (14), and a second metallic layer (16) extending through the layers (12, 13) of the stack (14) adjacent to the first ferroelectric layer (15), the first ferroelectric layer (15) forming, in combination with the plurality of first metallic layers (12) and the second metallic layer (16), a plurality of first capacitive memory cells;
wherein the method (50) comprises:
applying (51) a DC bias voltage to the first ferroelectric layer (15) by means of one of the first metallic layers (12) and the second metallic layer (16), wherein the DC bias voltage is lower than a voltage required to change a current polarization state of the first ferroelectric layer (15);
detecting (52) a capacitance of the first ferroelectric layer (15) at the bias voltage; and
correlating (53) the detected capacitance to a current polarization state of the first ferroelectric layer (15).

15. The method (50) of claim 14, wherein:
the capacitance of the first ferroelectric layer (15) is detected by applying an AC voltage signal to one side of the first ferroelectric layer (15) and detecting a dielectric response of the first ferroelectric layer (15) by means of the AC voltage signal at the other side of the first ferroelectric layer (15).
